Europäisches Patentamt

European Patent Office

Office européen des brevets

(11) Publication number: **0 170 912 B1**

## EUROPEAN PATENT SPECIFICATION

(45) Date of publication of patent specification: **09.10.91**   (51) Int. Cl.⁵: **G11C 5/06, G11C 11/406**

(21) Application number: **85108515.9**

(22) Date of filing: **09.07.85**

(54) Integrated circuit having a common input terminal.

(30) Priority: **09.07.84 JP 141803/84**

(43) Date of publication of application:
**12.02.86 Bulletin 86/07**

(45) Publication of the grant of the patent:
**09.10.91 Bulletin 91/41**

(84) Designated Contracting States:
**DE GB IT**

(56) References cited:
**FR-A- 2 533 738**
**US-A- 4 079 462**

**PATENT ABSTRACTS OF JAPAN, vol. 7, no. 266 (P-239)[1411], 26th November 1983; & JP-A-58 146 095 (OKI DENKI KOGYO K.K.) 31-08-1983**

(73) Proprietor: **NEC CORPORATION**
**7-1, Shiba 5-chome Minato-ku**
**Tokyo 108-01(JP)**

(72) Inventor: **Fukuzo, Yukio**
**c/o NEC Corporation 33-1, Shiba 5-chome**
**Minato-ku Tokyo(JP)**
Inventor: **Inoue, Yasukazu**
**c/o NEC Corporation 33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**W-8000 München 26(DE)**

## Description

The present invention relates to an integrated circuit having a common input terminal for a plurality of circuit blocks receiving signals via the common input terminal.

The integration density of integrated circuits has been increased and the number of elements and functional circuits fabricated in the same integrated circuit chip has become large. On the other hand, the number of external terminals provided in one integrated circuit chip has been limited in view of topographical layout of the chip and yields of production. Under such circumstance, it has been proposed that one external terminal is commonly utilized by two or more circuit blocks included in the same chip. For example, in the multi-strobe type dynamic memory in which row address signals and column signals are taken through the same set of address terminals in response to a row address strobe ($\overline{RAS}$) and a column address strobe ($\overline{CAS}$) respectively, the column address strobe is also used to control refresh operation, data outputting operation and serial column selecting operation. In this case, the column address strobe is applied to the circuit blocks for achieving the above operations. Therefore, the external terminal receiving the column address signal is directly connected to the inputs of the respective circuit blocks.

However, according to the above technique, since the common external terminal is directly connected to a plurality of circuit blocks, the capacitance associated to the common external terminal is inevitably very large, resulting in low speed operations. Moreover, each of the circuit blocks is provided with a special control circuit which prevents the circuit block from being affected by unnecessary input through the common external terminal after conducting it relevant function. This has made the respective circuit blocks complicated.

An integrated circuit according to the preamble part of claim 1 is disclosed in FR-A-2 533 738. This integrated circuit comprises a dynamic memory in which one of four drivers is connected to an input buffer through one of four gate circuits, wherein selection of the gate circuits is made in accordance with address signals. Therefore, once the state of the address signals is established, the connection between the input buffer and the drivers is determined so that control of the gates according to the states of the respective functional circuits to which input signals are selectively applied is not performed.

It is therefore an object of the invention to provide an integrated circuit in which a plurality of circuit blocks share the same external terminal which can operate at high speed and which can be fabricated an highly integrated structure.

This object is achieved by an integrated circuit as defined by claim 1.

According to the invention at least one circuit block is selectively isolated from the external terminal, wherein the gates are controlled by the states of the respective functional circuits to which input signals are selectively applied therethrough and hence the effective load capacitance associated to the external terminal is significantly reduced. Moreover since the circuit block is selectively isolated from the external terminal and the circuit block is not sensitive to the signal at the external terminal depending on the states of the respective functional circuit the signal at the external terminal does not adversely effect the circuit block.

Fig. 1 is schematic block diagram showing an integrated circuit according to the prior art;

Fig. 2 is a schematic block diagram of an integrated circuit comprising transfer gates;

Fig. 3 is a diagram showing waveforms in the circuit of Fig. 2;

Fig. 4 is a schematic block diagram of an embodiment of the present invention;

Fig. 5 is a diagram showing waveforms of the circuit of Fig. 4; and

Fig. 6 is a circuit diagram showing one example of the latch completion detection circuit 44' in Fig. 4.

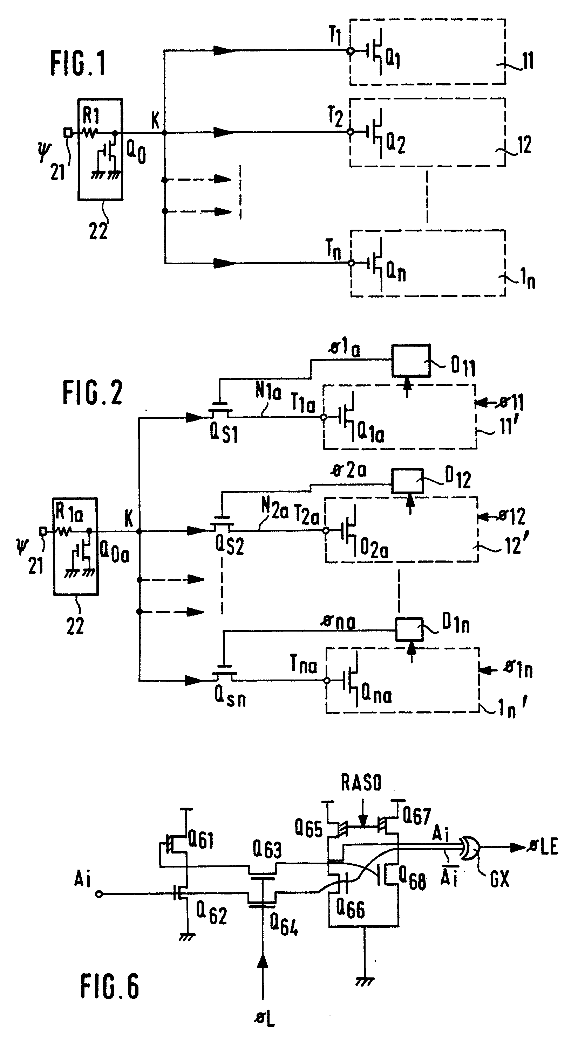

Referring to Fig. 1, an integrated circuit according to the prior art is briefly explained.

A plurality of circuit blocks $1_1$ to $1_n$ are provided in an integrated circuit. The circuit blocks $1_1$ to $1_n$ have different functions and include input transistors $Q_1$ to $Q_n$. To the gates of the input transistors $Q_1$ to $Q_n$ an external terminal 21 receiving a signal $\psi$ is commonly connected via an input protecting circuit 22 composed of a resistor $R_1$ and a transistor $Q_0$. Each of the circuit blocks $1_1$ to $1_n$ is adapted to be controlled by the logic pattern of the signal $\psi$ solely or with other signals such as $\phi_0$. For example, the circuit block $1_1$ is enabled in response to a high level of the signal $\psi$ while the circuit block $1_2$ is enabled in response to a low level when the signal $\phi_0$ is at high. Thus, the signal $\psi$ controls the respective circuit blocks in their own ways. However, according to the prior art, the signal $\psi$ is always applied to the inputs $T_1$ to $T_n$ of the circuit blocks even when some of the circuit blocks do not need the signal $\psi$ temporarily. Thus, the capacitance associated to a node K to which the output end of the input protecting circuit 22 is very large. Therefore, the propagation time of the signal $\psi$ from the terminal 21 to the respective inputs $T_1$ to $T_n$ of the circuit blocks is very large. This means that effective operation speeds of the respective circuit blocks are slow. Moreover, in order to drive the large capacitance associated to the node K, the

signal $\psi$ is required to have small internal impedance. Namely, the generator (not shown) of the signal $\psi$ must have the large driving capability.

Furthermore, since the signal $\psi$ is always applied to the respective circuit blocks, each of the circuit blocks has to be provided with circuit means for rendering the internal circuit (not shown) included therein insensitive to the operation of the input transistor when the circuit block do not need the signal $\psi$. Thus, the circuit structures of the circuit blocks have become complicated.

Referring to Fig. 2, the integrated circuit comprising transfer gates is described.

Inputs $T_{1a}$ to $T_{na}$ of the circuit blocks $1_1'$ to $1_{n'}$ are connected to the output node K of the input protecting circuit 22 via transfer gate transistors $Q_{S1}$ to $Q_{Sn'}$ respectively, as illustrated. The transfer gate transistors $Q_{S1}$ to $Q_{Sn}$ are controlled by control signals $\phi_{1a}$ to $\phi_{na}$. The signals $\phi_{1a}$ to $\phi_{na}$ are generated by detection circuits $D_{11}$ to $D_{1n}$ provided for the circuit blocks $1_1'$ to $1_{n'}$, respectively. The detection circuit $D_{11}$ monitors the operating state of the circuit block $1_1'$ and sets the control signal $\phi_{1a}$ at high level to render the transistor $Q_{S1}$ conductive when the circuit block needs to take the signal $\psi$ therein while the detection circuit $D_{11}$ sets the control signal $\phi_{1a}$ at low level to render the transistor $Q_{S1}$ non-conductive when the circuit block $1_1'$ does not need to receive the signal $\psi$. Other detection circuits $D_{12}$ to $D_{1n}$ control the transfer gate transistors $Q_{S2}$ to $Q_{Sn}$ in response to the states of the circuit blocks $1_2'$ to $1_{n'}$, respectively in the same manner.

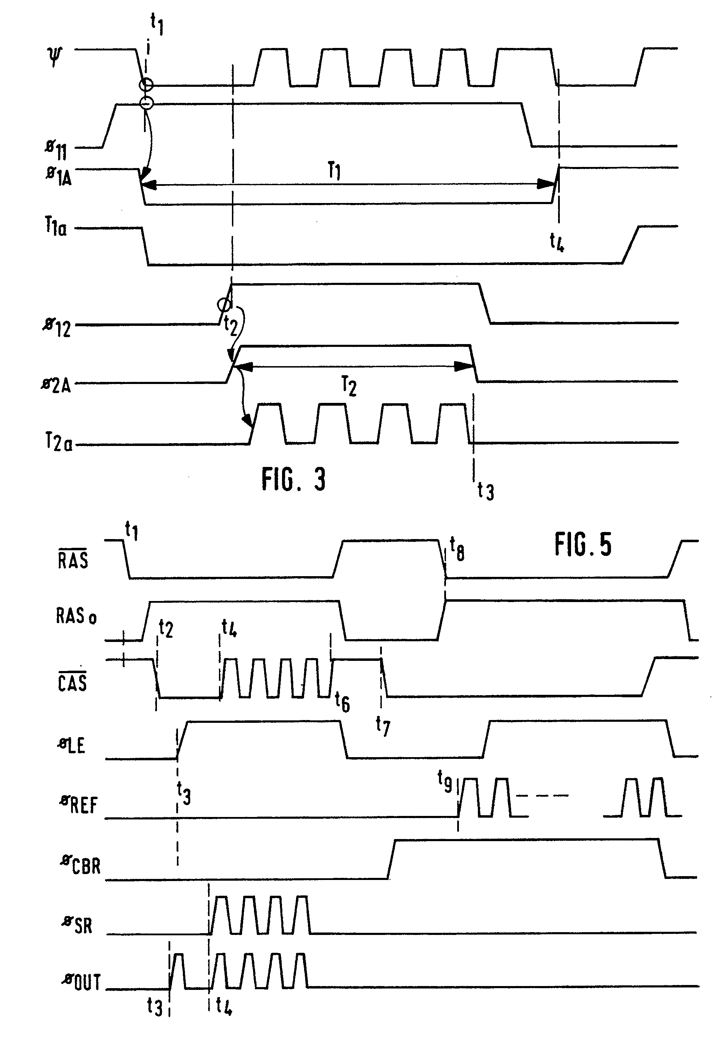

One example of operation of the circuit shown in Fig. 2 is explained with reference to Fig. 3. In the followings, by way of example, the explanation is made on the circuit blocks $1_1'$ and $1_{n'}$. At a time point $t_1$, the signal $\psi$ changes from high level to low level while a clock signal $\phi_{11}$ applied to the circuit block $1_1'$ is high. In response to this states of the signals, the circuit block $1_1'$ starts its operation such as storing data or the like over the subsequent period $T_1$ without necessitating the signals $\psi$. Therefore, the detection circuit $D_{11}$ produces a low level of the signal $\phi_{1a}$ thereby to render the transistor $Q_{S1}$ non-conductive so that the input $T_{1a}$ is kept low during the period $T_1$. While, a clock signal $\phi_{12}$ applied to the circuit block $1_2'$ changes from low level to high level so that the circuit block $1_2'$ enters into its operating mode over the subsequent period $T_2$. During this period $T_2$, the detection circuit $D_{12}$ sets the control signal $\phi_{2a}$ high so that the transfer gate transistor $Q_{S2}$ is rendered conductive. Accordingly, the signal $\psi$ is transmitted to the input $T_{2a}$ of the circuit block $1_2'$ during this period $T_2$. Thus, the circuit block $1_2'$ takes the signal $\psi$ in and performs operations based on the signal $\psi$ during the period $T_2$. While,

the waveform of the signal $\psi$ during the period does not affect the circuit block $1_1'$ because the transfer gate transistor $Q_{S1}$ is not conducting. Thus, the signal $\psi$ is rapidly transmitted to the input $T_{2a}$ during the period $T_2$. At a time point $t_3$, the clock signal $\phi_{12}$ changes from high level to low level so that the circuit block $1_2'$ enters into non-operating state. Then, in response to this, the detection circuit $D_{12}$ changes the control signal $\phi_{2a}$ from high level to low level thereby to isolate the input $T_{2a}$ of the circuit block $1_2'$ from the input terminal 22. Then, at a time point $t_4$, the signal $\psi$ changes from low level to high level under the low level of the clock signal $\phi_{11}$. Then, in response to this, the detection circuit $D_{11}$ sets the signal $\phi_{1a}$ high level to render the transfer gate transistor $Q_{S1}$ conductive. Thus, the circuit block $1_1'$ is rendered responsive to the signal $\psi$.

As described above, the signal $\psi$ is transmitted only to the circuit block or blocks which necessitate to take the signal $\psi$ therein, and hence the load capacitance associated to the terminal for receiving the signal $\psi$ is remarkably reduced.

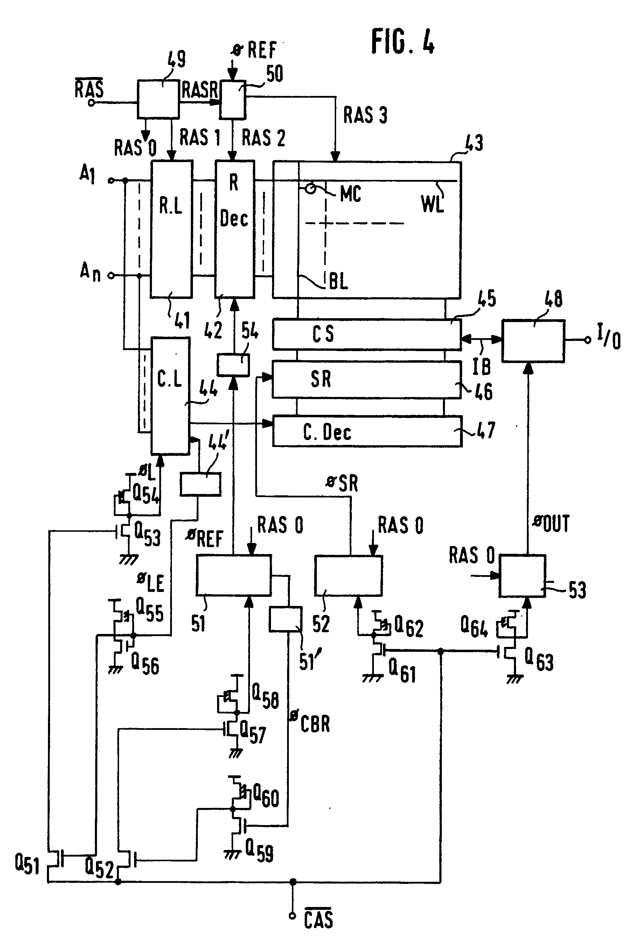

Referring to Figs. 4 and 5, a detailed embodiment of the present invention is described. This embodiment is the case where the principle according to Fig. 2 is applied to the multi-strobe type dynamic RAM.

Fig. 4. shows a block diagram of the multi-strobe type RAM to which the present invention is applied. A memory cell array 43 includes a plurality of dynamic type memory cells MC each coupled to one of word lines WL and one of bit lines BL and sense amplifiers (not shown). A row address signal latch circuit 41 is connected to a set of address input terminals $A_1$ to $A_n$ and latches the signals at the terminals $A_1$ to $A_n$ in response to a control signal RAS 1 which is generated by a first row timing signal generator 49 receiving a row address strobe $\overline{RAS}$. A row decoder 42 is coupled to the word lines and selects one of them in response to a control signal RAS 2 which is generated by a second row timing signal generator 50. A timing signal RAS 3 enables the sense amplifiers in the array. The respective bit lines BL are inputted to a column selection circuit 45 and the selection circuit 45 selectively connects the bit lines BL to a bus line IB which is coupled to an input/output circuit 48. The selection circuit 45 is controlled by a shift register 46 whose initial state is determined by column address decoder 47. The shift register 46 performs shift operations in response to a series of shift pulses $\phi_{SR}$ generated by a nibble mode control circuit 52. The column decoder 47 receives the row address signals latched by a row address latch circuit 44. An internal refresh control circuit 51 introduces self-refreshing operation into the memory when the $\overline{CAS}$ is first changed to low level and

thereafter the $\overline{RAS}$ is changed to low level. The internal refresh control circuit 51 produces a chain of refresh pulses $\phi_{REF}$ which are applied to a refresh address counter 54 and the second timing signal generator 50. When the memory is in the self-refreshing mode, the address counter 54 provides the row decoder 42 with refresh address signal and the generator 50 generates the signals RAS 2 and RAS 3 in response to $\phi_{REF}$. A control circuit 53 produces a control signal $\phi_{OUT}$ for enabling the circuit 48. In this arrangement the $\overline{CAS}$ is applied to the column latch circuit 44 via a transfer gate transistor $Q_{51}$ and an inverter composed of transistors $Q_{53}$ and $Q_{54}$. Also the $\overline{CAS}$ is applied to the refresh control circuit 51 via a transfer gate transistor $Q_{52}$ and an inverter composed of transistors $Q_{57}$ and $Q_{58}$. While, the $\overline{CAS}$ is applied to the control circuits 52 and 53 via an inverter composed of transistors $Q_{61}$ and $Q_{62}$ and an inverter composed of transistors $Q_{63}$ and $Q_{64}$, respectively. The transfer gate transistor $Q_{51}$ is located at the location close to the terminal $\overline{CAS}$ and the transfer gate transistor $Q_{52}$ is also located at the location close to the $\overline{CAS}$ terminal. Thus, the major wiring capacitance associated to the wiring connected to the gate of the transistor $Q_{53}$ and the major capacitance associated to the wiring connected to the gate of the transistor $Q_{57}$ are left behind the transfer gate transistors $Q_{51}$ and $Q_{52}$, respectively. Accordingly such major capacitances can be operatively isolated from the $\overline{CAS}$ terminal. The transfer gate transistor $Q_{51}$ is controlled by a latch completion detection circuit 44' and an inverter composed of the transistor $Q_{55}$ and $Q_{56}$. The circuit 44' generates a latch completion signal $\phi_{LE}$ when the latch circuit 44 completes its latching operation of column address signals.

One example of the detection circuit 44' is shown in Fig. 6. In Fig. 6 one-bit structure. of the column latch circuit 44 is shown. An address terminal $A_i$ is inputted to an inverter composed of transistors $Q_{61}$ and $Q_{62}$. Transistors $Q_{65}$ to $Q_{68}$ form a clocked type flip-flop circuit for holding the column address signal. The transistors $Q_{65}$ and $Q_{67}$ are of a depletion type and serve as gated-load in response to the signal RASO. Transfer gate transistors $Q_{63}$ and $Q_{64}$ transmit true and complementary signals of $A_i$ to the flip-flop in response to a signal $\phi_L$ generated by inverting $\overline{CAS}$ by the inverters of $Q_{53}$ and $Q_{54}$. Here an exclusive OR gate GX having inputs receiving true and complementary signals $A_i$ and $\overline{A_i}$ is provided. The gate GX detects that the flip-flop completes its latching operation of $A_i$ and $\overline{A_i}$. Thus the transfer gate transistor $Q_{51}$ is rendered conductive before the latching of the column address signals and non-conductive after the latching of the column address signals. The transfer gate transistor $Q_{52}$ is controlled by an output of an inverter composed of $Q_{59}$ and $Q_{60}$ receiving a signal $\phi_{CBR}$ which is generated by a refresh detection circuit 51' when the operation of the memory entered into the self-refreshing mode.

Fig. 5 shows waveforms showing operations of the memory of Fig. 4.

At time point $t_1$, $\overline{RAS}$ changes from high level to low level. In response to this change of $\overline{RAS}$, the signal RASO applied to the circuits 51 and 52 changes from low level to high level. Then, $\overline{CAS}$ changes high level to low level at time point $t_2$ so that the column latch circuit commences latch operation. In this instance, $\overline{CAS}$ is applied to the circuit 44 via the conductive transfer gate $Q_{51}$ because $\phi_{LE}$ is at low. Then at time point $t_3$, the signal $\phi_{LE}$ becomes high to render the transistor $Q_{51}$ non-conductive and the signal $\phi_{OUT}$ is once activated to achieve a first access operation. Then $\overline{CAS}$ is repeatedly changed between high and low levels from time point $t_4$ so that the memory into the nibble mode in which the signals $\phi_{SR}$ and $\phi_{OUT}$ are repeatedly generated in synchronism with the change of $\overline{CAS}$. Thus, data at a plurality of bit lines are sequentially accessed by the shift register 46. Thus, the nibble mode operation is achieved.

Then, operation is changed to the self-refreshing operation. Namely, $\overline{CAS}$ is changed from high level to low level at time point $t_7$ when $\overline{RAS}$ is at high. In response to this the control circuit 51, 51' introduces the self-refreshing mode into the memory and generates a high level of $\phi_{CBR}$ to render the transistor $Q_{52}$ non-conductive. Then, in response to change of $\overline{RAS}$ to low level, the refresh clock $\phi_{REF}$ is repeatedly generated to achieve self-refresh operations.

As has been described above, by way of examples the present invention is advantageous in reduction of the load capacitance associated to a common external terminal.

## Claims

1. An integrated circuit comprising a memory array (43) of memory cells arranged in rows and columns; a first terminal receiving a first control signal ($\overline{RAS}$); a second terminal for receiving a second control signal ($\overline{CAS}$); first means (41) responsive to said first control signal for holding row address signals; second means (42) for selecting the rows of said memory array; third means responsive to said first and second control signals for holding column address signals, said third means including a latch circuit (44) for holding column address signals, first connecting means (Q51, 44', Q55, Q56) coupled between said second terminal and a control input of said latch circuit (44); a refresh address counter (54) for operatively producing refresh address information; and a refresh control circuit (51, 51') responsive to said first and second control signals for enabling said refresh address counter, said refresh control circuit including, a refresh introducing circuit (51) and second connecting means (Q52, 51') coupled between said second terminal and said refresh introducing circuit, **characterized** in that said first connecting means includes a first switch (Q51) coupled between said second terminal and said control input of said latch circuit (44), means (44') coupled to said latch circuit for generating a latch completion signal ($\phi$LE), and means (Q55, Q56) responsive to said latch completion signal for rendering said first switch non-conducting; and said second connecting means includes a second switch (Q52) coupled between said second terminal and said refresh introducing circuit (51), a refresh state detection circuit (51') coupled to said refresh introducing circuit (51) for detecting that said refresh introducing circuit introduces refresh mode of said refresh counter and means (Q59, Q60) responsive to said refresh state detection circuit (51') for controlling said second switch.

2. The integrated circuit, according to claim 1, **characterized** in that each of said first and second switches includes a field effect transistor.

**Revendications**

1. Circuit intégré comprenant une matrice (43) de cellules de mémoire disposées en rangées et colonnes; une première borne recevant un premier signal de commande $\overline{(RAS)}$ ; une seconde borne pour recevoir un second signal de commande $\overline{(CAS)}$ ; un premier moyen (41) répondant audit premier signal de commande pour maintenir des signaux d'adresses de rangées; un second moyen (42) pour sélectionner les rangées de ladite matrice de mémoires; un troisième moyen répondant auxdits premier et second signaux de commande pour maintenir des signaux d'adresses de colonnes, ledit troisième moyen comprenant un circuit à bascule (44) pour maintenir des signaux d'adresses de colonnes; un premier moyen de connexion (Q51, 44', Q55, Q56) monté entre ladite seconde borne et une entrée de commande dudit circuit à bascule (44); un compteur d'adresses de régénération (54) pour produire fonctionnellement une information sur des adresses de régénération; et un circuit de commande de régénération (51, 51') répondant auxdits premier et second signaux de commande pour valider ledit compteur d'adresses de régénération, ledit circuit de commande de régénération comprenant un circuit d'introduction de régénération (51) et un second moyen de connexion (Q52, 51') monté entre ladite seconde borne et ledit circuit d'introduction de régénération, caractérisé en ce que ledit premier moyen de connexion comporte un premier commutateur (Q51) monté entre ladite seconde borne et ladite entrée de commande dudit circuit à bascule (44), un moyen (44') relié audit circuit à bascule pour produire un signal d'achèvement de bascule ($\phi$LE), et un moyen (Q55, Q56) répondant audit signal d'achèvement de bascule pour rendre non conducteur ledit premier commutateur; et ledit second moyen de connexion comprend un second commutateur (Q52) monté entre ladite seconde borne et ledit circuit d'introduction de régénération (51), un circuit de détection d'état de régénération (51') relié audit circuit d'introduction de régénération (51) pour détecter le fait que ledit circuit d'introduction de régénération introduit le mode régénération dudit compteur de régénération et un moyen (Q59, Q60) répondant audit circuit de détection de l'état de régénération (51') pour commander ledit second commutateur.

2. Circuit intégré selon la revendication 1, caractérisé en ce que chacun des premier et second commutateurs comprend un transistor à effet de champ.

**Patentansprüche**

1. Integrierte Schaltung mit einem Speicherfeld (43) aus Speicherzellen, die in Reihen und Spalten angeordnet sind; einer ersten Klemme, an der ein erstes Steuersignal $\overline{(RAS)}$ empfangen wird; einer zweiten Klemme zum Empfangen eines zweiten Steuersignals $\overline{(CAS)}$; ersten Mitteln (41), die auf das erste Steuersignal ansprechen zum Halten von Reihenadreßsignalen; zweiten Mitteln (42) zum Wählen der Reihen des Speicherfeldes; dritten Mitteln, die auf die ersten und zweiten Steuersignale ansprechen, zum Halten der Spaltenadreßsignale, wobei die dritten Mittel aufweisen einen Sperrschaltkreis (44) zum Halten der Spaltenadreßsignale, erste Verbindungsmittel (Q51, 44', Q55, Q56) die zwischen der zweiten Klemme und einem Steuerungseingang des Sperrschaltkreises (44) gekoppelt sind; einem Wiederholungsadreßzähler (54) zum operativen Erzeugen einer Wiederholungsadresseninformation; und einem Wiederholungssteuerschaltkreis (51, 51') der auf die ersten und zweiten Steuersignale anspricht, um den Wiederholungsadressenzähler freizugeben, wobei der Wiederholungssteuerschaltkreis einen Wiederholungseinleit-Schaltkreis (51) und zweite Anschlußmittel (Q52, 51') aufweist, die zwischen der zweiten Klemme und dem Wiederholungseinleitschaltkreis (51) gekoppelt sind;

dadurch **gekennzeichnet,** daß die ersten Anschlußmittel aufweisen einen ersten Schalter (Q51), der zwischen der zweiten Klemme und dem Steuerungseingang des Sperrschaltkreises (44) gekoppelt ist; an den Sperrschaltkreis gekoppelte Mittel (44'), um ein Sperren beendet - Signal ($\phi$LE), zu erzeugen und Mittel (Q55, Q56), die auf das Sperren beendet - Signal ansprechen, um den ersten Schalter nichtleitend zu machen; und die zweiten Anschlußmittel aufweisen einen zweiten Schalter (Q52), der zwischen der zweiten Klemme und dem Wiederholungseinleit-Schaltkreis (51) gekoppelt ist, einen Wiederholungsstatus-Detektorschaltkreis (51') der an den Wiederholungseinleit-Schaltkreis (51) gekoppelt ist, um zu detektieren, daß der Wiederholungseinleit-Schaltkreis den Wiederholungsmodus des Wiederholungszählers einleitet, und Mittel (Q59, Q6O) die auf den Wiederholungsstatus-Detektorschaltkreis (51') ansprechen, um den zweiten Schalter zu steuern.

2.   Integrierte Schaltung nach Anspruch 1, dadurch **gekennzeichnet,** daß jeder der ersten und zweiten Schalter einen Feldeffekttransistor aufweist.

EP 0 170 912 B1

FIG.1

FIG.2

FIG.6

EP 0 170 912 B1

FIG. 3

FIG. 5

8

# FIG. 4